(19) European Patent Office
Europäisches Patentamt
Office européen des brevets

(11) EP 0 969 499 A2

(12) **EUROPEAN PATENT APPLICATION**

(43) Date of publication:
05.01.2000 Bulletin 2000/01

(51) Int. Cl.7: **H01L 21/20**, H01L 31/18

(21) Application number: **99112809.1**

(22) Date of filing: **02.07.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **03.07.1998 JP 20288798**
**02.07.1998 JP 18846698**

(71) Applicant:
**CANON KABUSHIKI KAISHA**
**Tokyo (JP)**

(72) Inventors:
• **Iwane, Masaaki**
**Ohta-ku, Tokyo (JP)**

• **Nakagawa, Katsumi**
**Ohta-ku, Tokyo (JP)**
• **Nishida, Shoji**
**Ohta-ku, Tokyo (JP)**
• **Ukiyo, Noritaka**
**Ohta-ku, Tokyo (JP)**
• **Iwasaki, Yukiko**
**Ohta-ku, Tokyo (JP)**
• **Mizutani, Masaki**
**Ohta-ku, Tokyo (JP)**

(74) Representative:
**Grams, Klaus Dieter, Dipl.-Ing. et al**
**Patentanwaltsbüro**
**Tiedtke-Bühling-Kinne & Partner**
**Bavariaring 4**
**80336 München (DE)**

(54) **Crystal growth process for a semiconductor device**

(57) A crystalline silicon layer is epitaxially grown on a substrate having a porous silicon layer on the surface. In making epitaxial growth by liquid-phase epitaxy, a silicon material is previously dissolved in a melt at a high temperature and then the silicon substrate to be subjected to epitaxy is immersed in the melt. Then, its temperature is gradually lowered, whereby the silicon precipitated from the melt is epitaxially grown on the silicon substrate. In this epitaxy, a substrate having the principal plane of (111)-plane is used as the silicon substrate.

This provides a process by which a crystalline silicon layer covering a porous silicon layer completely is epitaxially grown on the porous silicon layer without causing any abnormal growth.

FIG. 1

EP 0 969 499 A2

## Description

BACKGROUND OF THE INVENTION

Field of the Invention

This invention relates to a crystal growth process, and a semiconductor device such as a solar cell and a process for its production. More particularly, this invention relates to a crystal growth process by which an epitaxial semiconductor is grown on a porous semiconductor, and a semiconductor device thereby formed and a process for its production.

Related Background Art

Because of combustion of oil in thermal power generation, combustion of gasoline by automobile engines and so forth, emission of the green-house effect gases such as carbon dioxide and nitrogen oxides causes pollution of the global environment. Also, there is an anxiety about exhaustion of crude oil in future. Accordingly, solar cell power generation draws increasing interest as a clean energy source.

Thin-film crystalline silicon (Si) solar cells have so thin electricity generation layers as to require only a small quantity of silicon materials used, and hence enable achievement of low cost. Also, since crystalline silicon is used in the electricity generation layers, a high conversion efficiency and a low deterioration can be expected, compared with amorphous silicon solar cells. Moreover, since thin-film crystalline silicon solar cells can be bent to a certain extent, they can be attached to curved portions of automobile bodies, household electric appliances, roof tiles and so forth when used.

In order to materialize such thin-film crystalline silicon solar cells, as disclosed in Japanese Patent Application Laid-Open No. 8-213645, an epitaxial layer formed on a porous silicon layer is utilized to separate a thin-film single-crystal silicon.

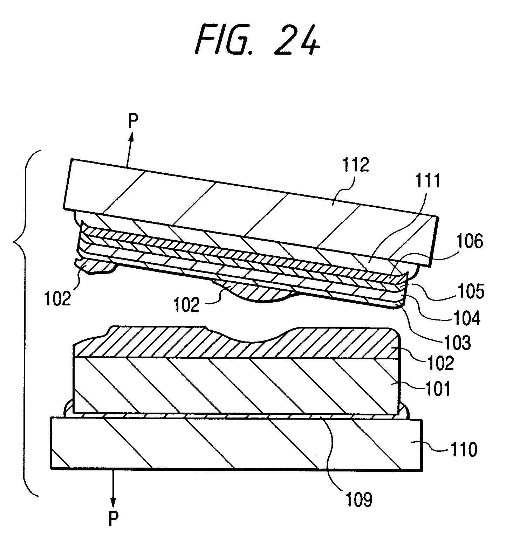

Fig. 24 is a cross-sectional view showing a process of forming a thin-film crystalline silicon solar cell, disclosed in that publication. In Fig. 24, reference numeral 101 denotes a silicon wafer; 102, a porous silicon layer; 103, a p$^+$-type silicon layer; 104, a p$^-$-type silicon layer; 105, an n$^+$-type silicon layer; 106, a protective layer; 109 and 111, adhesives; and 110 and 112, jigs.

In the solar cell production process shown in Fig. 24, the porous silicon layer 102 is formed on the silicon wafer 101 by anodizing. Thereafter, the p$^+$-type silicon layer 103 is epitaxially grown (epitaxial silicon layer) on the porous silicon layer 102, and further thereon the p$^-$-type silicon layer 104 and n$^+$-type silicon layer 105 are epitaxially grown (both epitaxial silicon layers). Then, the protective layer 106 is formed thereon. Then, adhesives 109 and 111 are applied to the protective layer 106 and the silicon wafer 101 to bond them to the jigs 110 and 112 respectively. Thereafter, a tensile force P is made to act on the jigs 110 and 112 to separate the epitaxial silicon layers 103, 104 and 105 from the silicon wafer 101 at the porous silicon layer 102. Then, a solar cell is formed using the epitaxial silicon layers 103, 104 and 105. The silicon wafer 102 is again put into a similar process so as to make cost reduction.

Japanese Patent Application Laid-Open No. 5-283722 also discloses that an epitaxial silicon layer is grown on a porous silicon layer by liquid-phase epitaxy. Tin (Sn) is used as a melt. Before the epitaxy, the tin is previously dissolved in silicon and the solution formed is kept saturated. Next, annealing is started, and, at the time the tin solution has become supersaturated to a certain degree, the porous surface of the wafer is immersed in the solution to grow an epitaxial silicon layer on the porous surface.

Now, in making epitaxial growth on porous silicon layers to produce semiconductor devices such as solar cells, it is ideal to form the epitaxial silicon layer on the porous silicon layer in a uniform layer and to cover the porous silicon layer completely with the epitaxial silicon layer. For example, in the process disclosed in the above Japanese Patent Application Laid-Open No. 8-213645, any part not covered completely with the epitaxial silicon layer and at which the porous silicon layer is uncovered causes a leak of electric currents when a solar cell is formed, so that only a low conversion efficiency can be attained. Also, if the porous silicon layer can not completely be covered with the epitaxial silicon layer, difficulties may arise in any subsequent steps even in the case of other semiconductor devices. For example, when, as disclosed in the above Japanese Patent Application Laid-Open No. 8-213645, CMOS is formed in the epitaxial silicon layer on the porous silicon layer, the epitaxial silicon layer must be spread uniformly. Thus, it is desired that an epitaxial layer spreading uniformly on the porous silicon layer be grown in a good yield.

In the case where, however, the epitaxial silicon layer is grown on the porous silicon layer by liquid-phase epitaxy, use of a silicon wafer having the principal plane of (100)-plane may cause pyramidal abnormal growth on the porous silicon layer, so that the epitaxial silicon does not cover the porous silicon layer completely and the porous silicon layer remains uncovered.

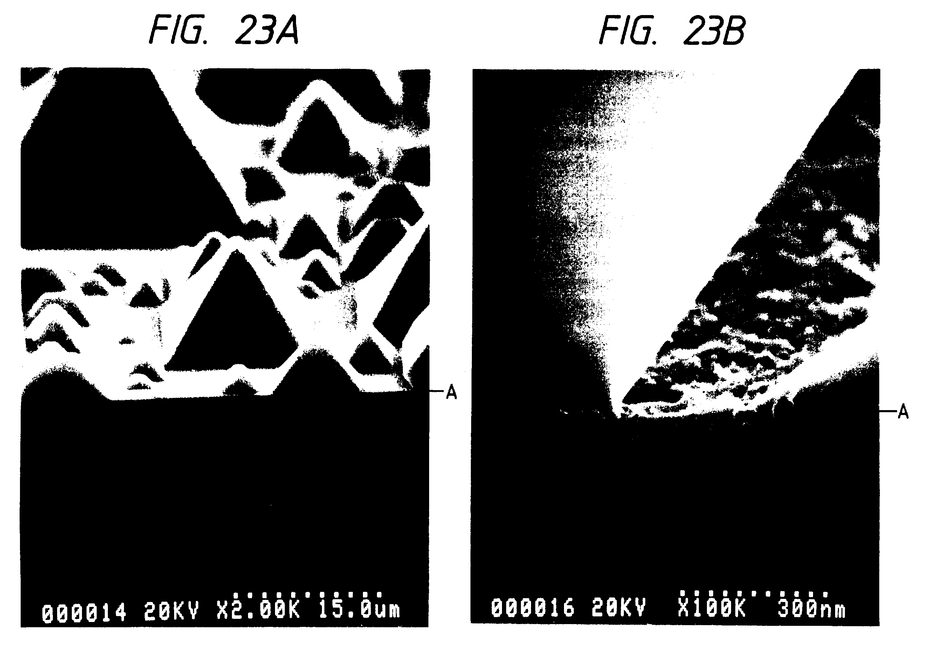

More specifically, pyramidal abnormal growth takes place on the surface as shown in Fig. 23A, a cross-sectional photograph taken by scanning electron microscopy (SEM). In Fig. 23A, the part lower than a solid line A is a cross section, and the part upper than the solid line A is the surface. What look pyramidal are epitaxial silicon regions. The porous silicon layer surfaces are seen between the pyramidal epitaxial silicon regions. Fig. 23B is an enlarged cross-sectional photograph of Fig. 23A, in which similarly the part lower than a solid line A is a cross section, and the part upper than the solid line A is the surface. As can clearly be seen from Fig. 23B, a porous silicon layer having pores is present right beneath the pyramidal and the porous silicon layer is not completely covered with the epitaxial silicon and stands uncovered to the surface. The substrate on which such an abnormal growth has taken place can no longer be sent to the subsequent steps, resulting in a poor production yield.

## SUMMARY OF THE INVENTION

Accordingly, an object of the present invention is to provide a crystal growth process that can form stratified epitaxial semiconductor layers stably on a porous layer, and a process for producing semiconductor devices in a good yield by applying such a crystal growth process. Another object thereof is to provided a semiconductor device having a good production yield.

To achieve the above objects, the present inventors have made effort extensively. As a result, they have accomplished the following invention. That is, the crystal growth process of the present invention is a crystal growth process comprising forming an epitaxial semiconductor layer on a porous semiconductor, wherein the porous semiconductor layer has the principal plane of (111)-plane. Here, the porous semiconductor may preferably be formed by subjecting the surface of a (111) silicon wafer to anodizing. Also, as the crystal growth, liquid-phase epitaxy may preferably be used. However, the present invention may also be applied to gaseous-phase growth. The epitaxial semiconductor may preferably be silicon, or may also be a compound semiconductor such as GaAs.

The present invention also embraces a semiconductor device production process. More specifically, the semiconductor device production process of the present invention comprises forming a porous semiconductor on the surface of a semiconductor substrate, and forming on the porous semiconductor an epitaxial semiconductor layer used as an active layer, wherein the semiconductor substrate has the principal plane of (111)-plane.

The present invention still also embraces a semiconductor device. More specifically, the semiconductor device of the present invention comprises a substrate and formed thereon an active layer having the principal plane of (111)-plane; the active layer being used in photoelectric conversion. Here, where an angle formed by any arbitrary two cutting lines not coming into coincidence is represented by $\theta$, the active layer may preferably have a cutting angle of $|\cos\theta| = 1/2$ or $3^{1/2}/2$. More preferably, angles formed by all arbitrary two cutting lines not coming into coincidence may satisfy $|\cos\theta| = 1/2$ or $3^{1/2}/2$. Cutting the active layer in this way enables effective utilization of the precious material silicon while making the most of cleavability of the (111) substrate. This semiconductor device may preferably be a solar cell, which, however, may also include usual semiconductor devices such as photosensors.

In order to make the present invention most effective, the principal plane of the porous semiconductor, the principal plane of the porous semiconductor substrate and the principal plane of the active layer may preferably be strict (111)-plane. However, the present invention can be effective also when the principal plane deviates slightly from the (111)-plane (e.g., when a commercially available (111) silicon substrate is used). More specifically, an instance where the porous semiconductor layer is formed on what is commonly called the (111) substrate (those not having the (111)-plane as the principal plane when stated strictly) and an instance where such a substrate is used as the semiconductor substrate or as the active layer are within the scope of the present invention. The deviation of principal plane from the strict (111) plane may preferably be within 24', more preferably within 8', and still more preferably within 3'.

## BRIEF DESCRIPTION OF THE DRAWINGS

Fig. 1 is a diagrammatic top plan view of a liquid-phase growth system according to Embodiment 1.
Fig. 2 is a cross section along the line 2-2 in Fig. 1.
Figs. 3A and 3B illustrate a solar cell produced in Embodiment 1. Fig. 3A is a diagrammatic perspective view, and Fig. 3B a diagrammatic cross-sectional view.
Figs. 4A, 4B, 4C, 4D and 4E are diagrammatic cross-sectional views showing steps of a process for producing a solar cell in Embodiment 1.
Figs. 5A, 5B and 5C are diagrammatic cross-sectional views showing subsequent steps of the process for producing a solar cell in Embodiment 1.
Figs. 6A and 6B are diagrammatic cross-sectional views of anodizing units.
Fig. 7 is a time chart showing the sequence of liquid-phase growth in Embodiment 1.
Fig. 8 is a diagrammatic perspective view of a wafer cassette and silicon wafers.
Figs. 9A and 9B are diagrammatic top plan views for illustrating how to cut a solar cell in Embodiment 1.
Fig. 10 is a plan view showing the manner of arrangement of unit cells of a solar cell in Embodiment 1.
Figs. 11A and 11B are plan views also showing the manner of arrangement of unit cells of a solar cell in Embodiment 1.
Figs. 12A, 12B, 12C and 12D are diagrammatic cross-sectional views showing steps of a process for producing a solar cell in Embodiment 2.
Figs. 13A, 13B, 13C, 13D and 13E are diagrammatic cross-sectional views showing subsequent steps of the process for producing a solar cell in Embodiment 2.

Figs. 14A, 14B, 14C and 14D are diagrammatic cross-sectional views showing further steps of the process for producing a solar cell in Embodiment 2.

Fig. 15 is a diagrammatic perspective view of the solar cell in Embodiment 2.

Fig. 16 is a diagrammatic top plan view of a liquid-phase growth system according to Embodiment 2.

Fig. 17 is a time chart showing the sequence of liquid-phase growth in Embodiment 2.

Fig. 18 is a diagrammatic top plan view of a liquid-phase growth system according to Embodiment 3.

Fig. 19, comprised of Figs. 19A and 19B, is a time chart showing the sequence of liquid-phase growth in Embodiment 3.

Figs. 20A and 20B are diagrammatic cross-sectional views of a liquid-phase growth system used in Example.

Figs. 21A and 21B are also diagrammatic cross-sectional views of a liquid-phase growth system used in Example.

Figs. 22A and 22B are cross-sectional photographs taken by scanning electron microscopy (SEM).

Figs. 23A and 23B are cross-sectional photographs taken by scanning electron microscopy (SEM).

Fig. 24 is a diagrammatic cross-sectional view showing a conventional solar cell production process.

DESCRIPTION OF THE PREFERRED EMBODIMENTS

Embodiments of the present invention will be described in detail with reference to the accompanying drawings. Three Embodiments will be given below. Without limitation to these Embodiments, any appropriate combinations of these are also embraced in the scope of the present invention.

(Embodiment 1)

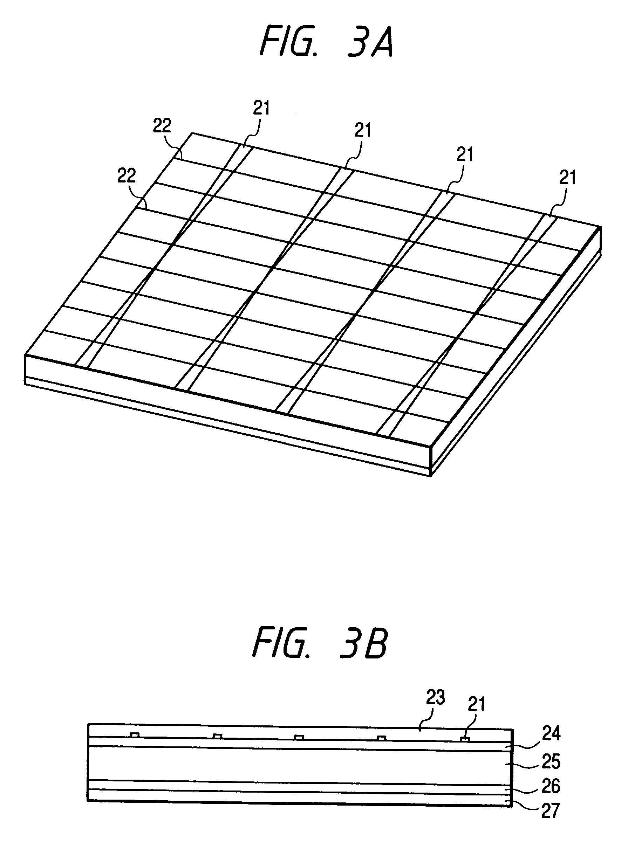

Figs. 3A and 3B are diagrammatic illustrations of a solar cell produced in Embodiment 1. Fig. 3A is a perspective view, and Fig. 3B a cross-sectional view. In Figs. 3A and 3B, reference numeral 21 denotes bus bars; 22, fingers; 23, an anti-reflection layer; 24, an $n^+$-type silicon layer; 25, a $p^-$-type silicon layer; 26, a $p^+$-type silicon layer; and 27, a SUS stainless steel substrate. The bus bars 21 and fingers 22 constitute the surface electrode serving as an electrode on the negative-pole side. The SUS stainless steel substrate 27 constitutes the back electrode (positive-pole side). The $n^+$-type silicon layer 24, $p^-$-type silicon layer 25 and $p^+$-type silicon layer 26 are formed by liquid-phase epitaxy of silicon single crystals.

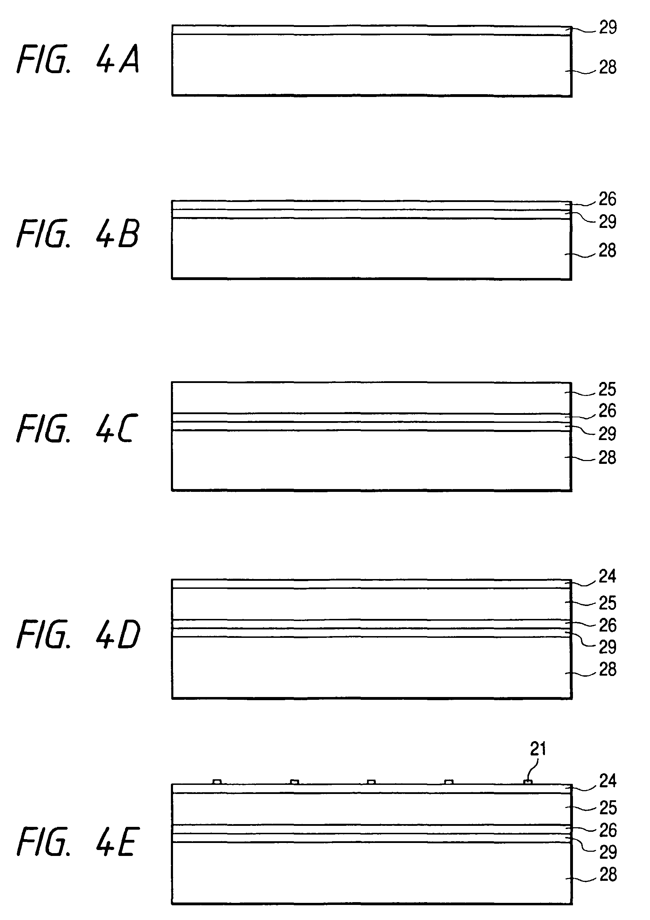

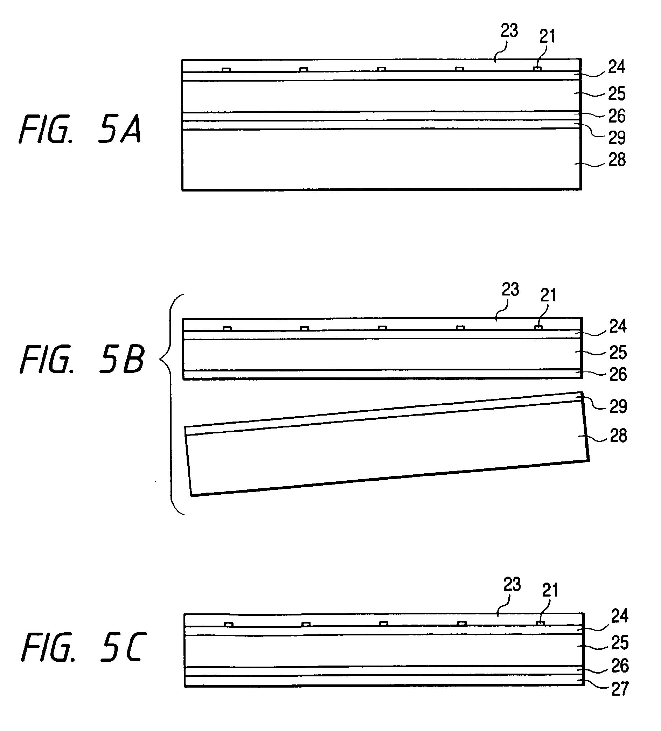

Figs. 4A to 4E and Figs. 5A to 5C are diagrammatic cross-sectional views showing a process for producing a single-crystal solar cell in Embodiment 1. First, as shown in Fig. 4A, a porous silicon layer 29 is formed on the surface of a (111) silicon wafer 28. The porous silicon layer 29 can be formed by subjecting the surface of the silicon wafer 28 to anodizing.

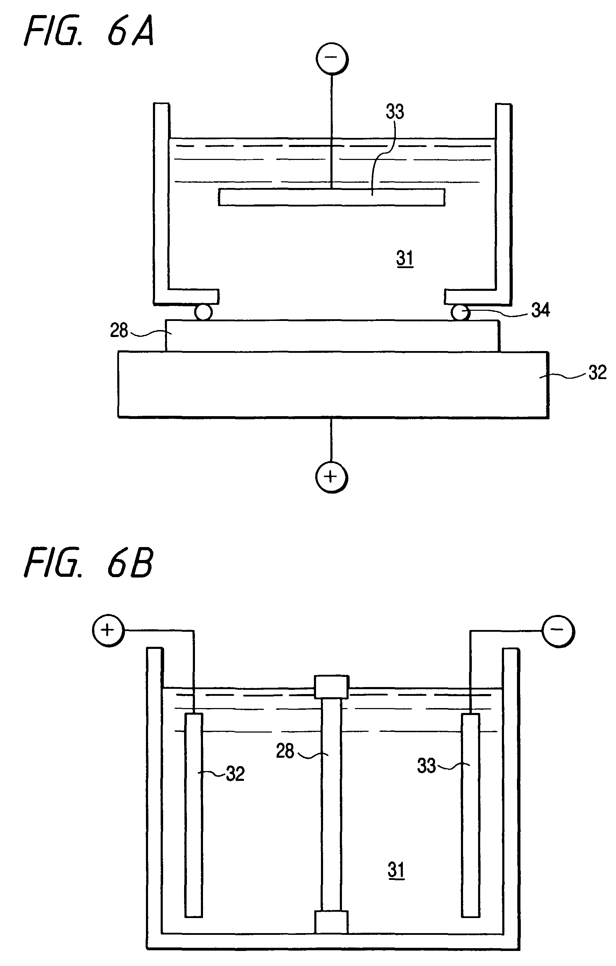

Figs. 6A and 6B are diagrammatic cross-sectional views of units for anodizing silicon wafers with a hydrofluoric acid type etchant. In Figs. 6A and 6B, reference numeral 28 denotes the silicon wafer; 31, the hydrofluoric acid type etchant; 32 and 33, metal electrodes; and 34, an O-ring. In Embodiment 1, the unit shown in Fig. 6A is used. As shown in Fig. 6A, setting the lower-side metal electrode 32 positive and the upper-side metal electrode 33 negative, a voltage is applied across the both electrodes. The unit is so set up that the electric field caused by this voltage is applied in the direction perpendicular to the surface of the silicon wafer 28, thus the upper side of the silicon wafer 28 is made porous. In the unit shown in Fig. 6B, the potentials of the electrodes are reversed, whereby the both sides of the silicon wafer 28 can be made porous.

The silicon wafer 28 to be anodized may preferably be of the p-type, but may also be of the n-type so long as it has a low resistance. Even n-type wafers can be made porous by being irradiated by light and brought into the state where pores are formed. The hydrofluoric acid type etchant 31 is prepared using concentrated hydrofluoric acid (e.g., 49% HF). During the anodizing, air bubbles are produced from the silicon wafer 28, and hence alcohol is added as a surfactant in some cases so that the air bubbles can be removed in a good efficiency. As the alcohol, methanol, ethanol, propanol or isopropanol is preferred. Also, in place of the surfactant, a stirrer may be used so as to carry out anodizing with stirring. The surface layer to be anodized may be in a thickness (depth) of from 1 to 30 μm.

After the porous silicon layer 29 is formed on the silicon wafer 28 in the step as described above and as shown in Fig. 4A, the $p^+$-type silicon layer 26 is epitaxially grown by liquid-phase epitaxy as shown in Fig. 4B. Although the porous silicon layer has a structure provided with pores, its single-crystal nature stands maintained. Hence, the epitaxial growth can be made on the porous silicon layer. Thereafter, as shown in Fig. 4C, the single-crystal $p^-$-type silicon layer 25 is formed also by liquid-phase epitaxy. Next, as shown in Fig. 4D, the single-crystal $n^+$-type silicon layer 25 is formed by liquid-phase epitaxy.

Thereafter, as shown in Fig. 4E, a grid electrode 21 is formed on the surface of the $n^+$-type silicon layer 24 by a process such as printing, and fingers 22 (not shown) are similarly formed. Next, as shown in Fig. 5A, the anti-reflection layer 23 is formed on the grid electrode 21 and $n^+$-type silicon layer 24.

Then, as shown in Fig. 5B, the silicon layers 24, 25 and 26, which are to form a solar cell, are separated from the silicon wafer 28 at the porous silicon layer 29. The porous silicon layer 29 have a brittle structure compared with the silicon wafer 28 and silicon layers 24, 25, 26 formed by epitaxial growth. Hence, the single-crystal silicon layers 24, 25 and 26 can be separated from the silicon wafer 28 at the porous silicon layer 29 by a method in which a tape is stuck to the surface of the anti-reflection layer 23 to separate the former from the latter, or a wedge is driven from the lateral side, or water narrow-streamed and jetted out under a high pressure is used as if it is a "wedge".

Then, as shown in Fig. 5C, the SUS stainless steel substrate 27 is attached to the bottom surface of the $p^+$-type silicon layer 26, thus a unit cell of a solar cell is completed.

The silicon wafer 28 separated in the separation step shown in Fig. 5B is, after the porous silicon layer 29 has been removed from its surface, again used repeatedly in the process starting from the step shown in Fig. 4A. Thus, the silicon wafer 28 is used many times in the production of unit cells of a solar cell. It is desirable to use one sheet of silicon wafer 28 100 or more times to produce 100 or more unit cells of a solar cell from one sheet of silicon wafer 28.

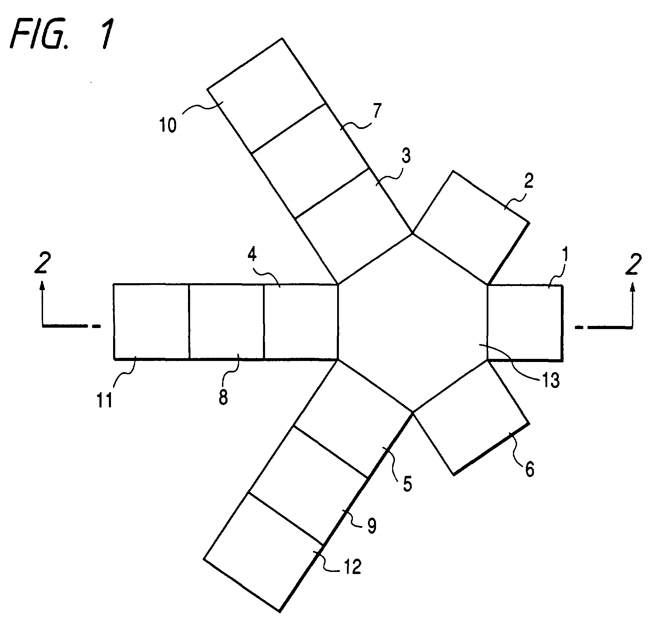

Fig. 1 is a diagrammatic top plan view of a three-crucible liquid-phase growth system. In Fig. 1, reference numeral 1 denotes a loading chamber (L/C); 2, a hydrogen annealing chamber; 3, a $p^+$-type silicon layer 26 growth chamber; 4, a $p^-$-type silicon layer 25 growth chamber; 5, an $n^+$-type silicon layer 24 growth chamber; 6, an unloading chamber (UL/C); and 13, a core into which a substrate cassette is to be transported. Reference numerals 7, 8 and 9 denote transport chambers through which silicon materials are fed into the $p^+$-type silicon layer, $p^-$-type silicon layer and $n^+$-type silicon layer growth chambers, respectively; 10, 11 and 12 denote feed chambers of silicon materials for the $p^+$-type silicon layer, $p^-$-type silicon layer and $n^+$-type silicon layer growth chambers, respectively.

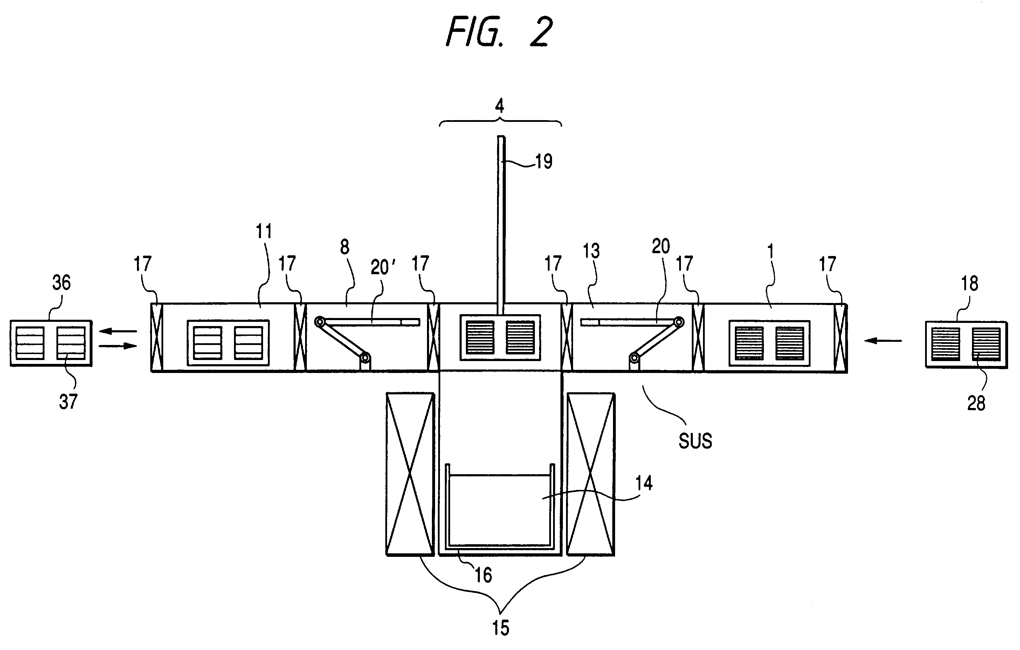

To carry out liquid-phase epitaxy, first, a wafer cassette 18 (Fig. 2) in which silicon wafers 28 each having the porous silicon layer 29 on the surface are held horizontally is put into the loading chamber (L/C) 1. Then, using a transport means provided in the core 13, the wafer cassette 18 having been put into the loading chamber (L/C) 1 is moved to the hydrogen annealing chamber 2 to carry out hydrogen annealing. Thereafter, the wafer cassette 18 is moved in the order of the $p^+$-type silicon layer 26 growth chamber 3, $p^-$-type silicon layer 25 growth chamber 4 and $n^+$-type silicon layer 24 growth chamber 5, and the $p^+$-type silicon layer 26, $p^-$-type silicon layer 25 and $n^+$-type silicon layer 24 are formed on the porous silicon layer 29 as shown in Figs. 4B to 4D.

A cross section of the Fig. 1 system along the line 2-2 is shown in Fig. 2. In Fig. 2, reference numeral 14 denotes a melt; 15, a heater; 16, a crucible; 18, the wafer cassette; 19, a vertical-direction transport means; 20, a horizontal-direction transport means; 36, a dissolve-in substrate cassette; and 37, dissolve-in substrates. Members denoted by the same reference numerals described previously are the same members as those described above, and description thereon is omitted.

The loading chamber 1 stands isolated from the core 13 and the open air by gate valves 17. Into the loading chamber 1, the wafer cassette 18 can be introduced on releasing the gate valve 17 provided on the right side of the loading chamber 1. Also, on releasing the gate valve 17 provided on the left side of the loading chamber 1, the wafer cassette 18 can be moved to the $p^-$-type silicon layer growth chamber 4 using the horizontal-direction transport means 20 provided in the core 13.

The silicon material feed chamber 11 is so set up that the dissolve-in substrate cassette 36 can be put in and out on opening its left-side gate valve 17. Also, on releasing the right-side gate valve 17, the dissolve-in substrate cassette 36 can be moved to the $p^-$-type silicon layer growth chamber 4 using a horizontal-direction transport means 20' provided in the transport chamber 8.

The $p^-$-type silicon layer growth chamber 4 has the vertical-direction transport means 19, which moves the wafer cassette 18 and dissolve-in substrate cassette 36 upward or downward. The vertical-direction transport means 19 can immerse the wafer cassette 18 and dissolve-in substrate cassette 36 into the melt 14 held in the crucible 16. A heater 15 apply high-temperature heat to the melt 14 to keep the melt 14 being liquid.

The $p^+$-type silicon layer growth chamber 3, transport chamber 7 and silicon material feed chamber 10 and also the $n^+$-type silicon layer growth chamber 5, transport chamber 9 and silicon material feed chamber 10 have the same cross-sectional structure as that in Fig. 2.

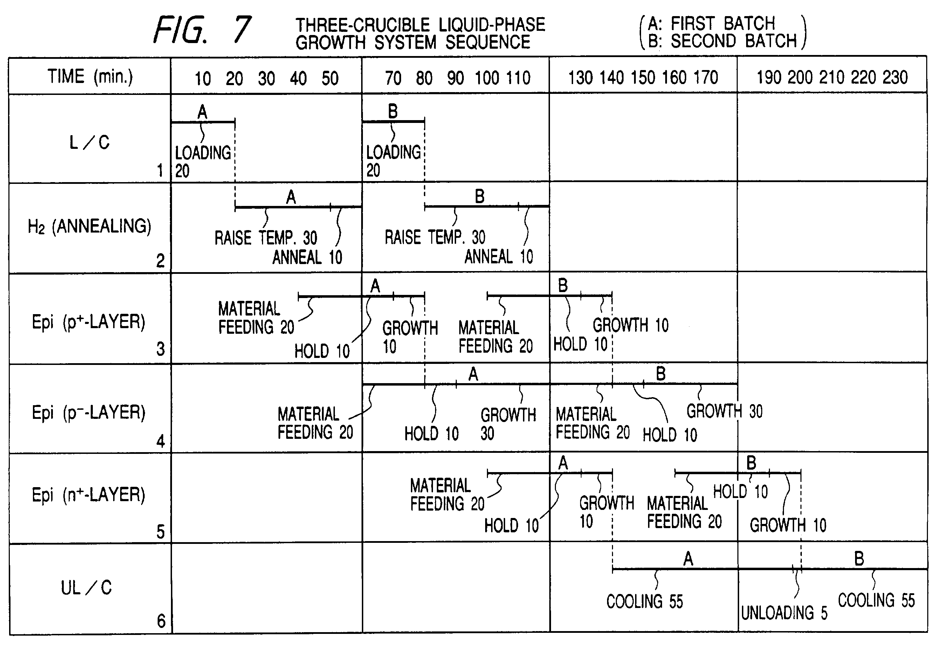

Fig. 7 is a time chart showing the sequence in which the liquid-phase growth system shown in Fig. 1 is operated. Letter symbol A represents the movement of the wafer cassette in the first batch.

The first-batch wafer cassette 18 is loaded in the loading chamber 1 in the first 20 minutes, and is transported to the hydrogen annealing chamber 2. In the hydrogen annealing chamber 2, it takes 30 minutes to raise the temperature of the wafer cassette 18, and hydrogen annealing is carried out for 10 minutes. The hydrogen annealing is carried out in an atmosphere of hydrogen at about 1,040°C. During the hydrogen annealing or immediately thereafter, a trace amount of $SiH_4$ (silane) may be flowed so that the surface properties of the porous silicon layer 29 can be kept improved.

Then, the wafer cassette 18 is moved to the $p^+$-type silicon layer growth chamber 3 while using the horizontal-direction transport means 20 of the core 13, and the wafer cassette 18 is held for 10 minutes until it reaches the growth temperature. In this course, the melt 14 is cooled and the $p^+$-type silicon becomes supersaturated. Before the wafer cassette 18 is moved to the $p^+$-type silicon layer growth chamber 3, the dissolve-in substrate cassette 36 holding $p^+$-type silicon wafers and so forth is transported from the silicon material feed chamber 10 through the transport chamber 7 and immersed in the melt 14 kept at a high temperature, and the $p^+$-type silicon is kept dissolved in the melt 14. As materials for the melt 14, indium (In) and tin (Sn) are available. Then, using the vertical-direction transport means 19, the wafer cassette 18 is immersed in the melt 14, and the temperature of the melt 14 is gradually lowered, whereupon the $p^+$-type silicon layer 26 is epitaxially grown on the surface of the porous silicon layer 29. This growth time is about 10 minutes.

Thereafter, the wafer cassette 18 is drawn up from the melt 14, and is moved to the $p^-$-type silicon layer growth chamber 4, where it is similarly held for 10 minutes to make the melt 14 become supersaturated with $p^-$-type silicon. Here, the dissolve-in substrate cassette 36 holding $p^-$-type silicon substrates is previously immersed in the melt 14 in the same way, and the $p^-$-type silicon is kept dissolved in the melt 14 for 20 minutes. Then, the wafer cassette 18 is immersed in the melt 14, and the temperature of the melt 14 is gradually lowered, whereupon the $p^-$-type silicon layer 25 is epitaxially grown on the $p^+$-type silicon layer 26. This growth time is about 30 minutes. In this immersion time, the $p^-$-type silicon layer 25 is grown in a thickness of about 30 μm.

Thereafter, the wafer cassette 18 is drawn up from the melt 14, and is moved to the $n^+$-type silicon layer growth chamber 5, where it is similarly held for 10 minutes to make the melt 14 become supersaturated with $n^+$-type silicon. Here, the dissolve-in substrate cassette 36 holding $n^+$-type silicon substrates is previously immersed in the melt 14 in the same way, and the $n^+$-type silicon is kept dissolved in the melt 14 for 20 minutes. Then, the wafer cassette 18 is immersed in the melt 14, and the temperature of the melt 14 is gradually lowered, whereupon the $n^+$-type silicon layer 24 is epitaxially grown on the $p^-$-type silicon layer 25. This growth time is about 10 minutes.

Thereafter, the wafer cassette 18 is drawn up from the melt 14, and is moved to the unloading chamber 6, where it is cooled for 55 minutes and brought back to room temperature. Thereafter, in the last 5 minutes, the wafer cassette 18 is taken out of the liquid-phase growth system.

Letter symbol B represents the movement of the wafer cassette 18 in the second batch. The second-batch wafer cassette is also moved according to the time chart shown in Fig. 7, and is moved in the same manner as the first-batch wafer cassette, thus the description is omitted. According to the liquid-phase growth system of Embodiment 1, the liquid-phase epitaxy can be made on new wafer cassettes at intervals of 60 minutes.

According to the liquid-phase growth system of Embodiment 1, as shown at 130 to 140 minutes in Fig. 7, the liquid-phase epitaxy is made simultaneously in the chamber 3 for growing the $p^+$-type silicon layer and chamber 5 for growing the $n^+$-type silicon layer. Also, as shown at 110 to 120 minutes in Fig. 7, the annealing in the hydrogen annealing chamber 2 and the liquid-phase epitaxy in the chamber 4 for growing the $p^-$-type silicon layer are made simultaneously. Still also, as shown at 50 to 60 minutes in Fig. 7, the annealing in the hydrogen annealing chamber 2 and the dissolving of semiconductor material in the chamber for growing the $p^+$-type silicon layer are made simultaneously.

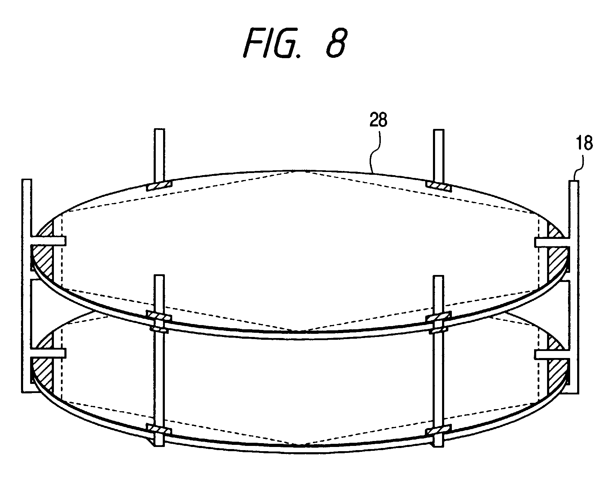

Fig. 8 is a perspective view of the wafer cassette 18 of the liquid-phase growth system and (111) silicon wafers set in the wafer cassette 18. The solar cell active layer grown epitaxially on each silicon wafer 28 is cut into a regular hexagon after the separation step shown in Fig. 5B, utilizing its cleavage direction. Hence, at the edge portions of the active layer which are cut off and discarded, the silicon wafer 28 is held by the wafer cassette 18 so that the solar cell active layer can be free from any unevenness after cutting. Also, since the epitaxial growth is interrupted at that portions to be discarded, the silicon in the melt can be saved.

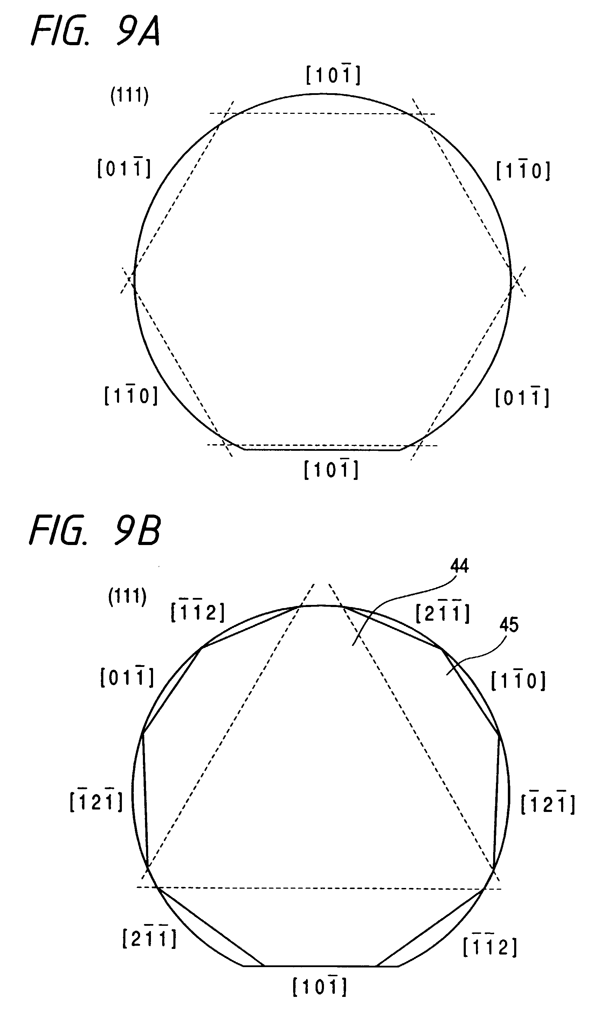

Figs. 9A and 9B are top plan views of the solar cell active layers to be cut. Fig. 9A shows the cutting in a regular hexagon, and Fig. 9B shows the cutting in a regular triangle. Cleavage directions of the (111) silicon wafer are the following six directions.

$$[1\bar{1}0],\ [01\bar{1}],\ [10\bar{1}],\ [2\bar{1}\bar{1}],\ [\bar{1}2\bar{1}]\ \text{and}\ [\bar{1}\bar{1}2].$$

Utilization of these cleavage directions facilitates the cutting into the hexagon as shown by dotted lines in Fig. 9A, or the triangle as shown by dotted lines in Fig. 9B. Namely, where an angle formed by any arbitrary two cutting lines not coming into coincidence is represented by θ, a cutting angle of $|\cos\theta| = 1/2$ or $3^{1/2}/2$ tends to be formed. Use of such cutting lines enables clear cutting without causing any burrs or abnormal cut lines to run across the single-crystal active layer on the (111) silicon wafer.

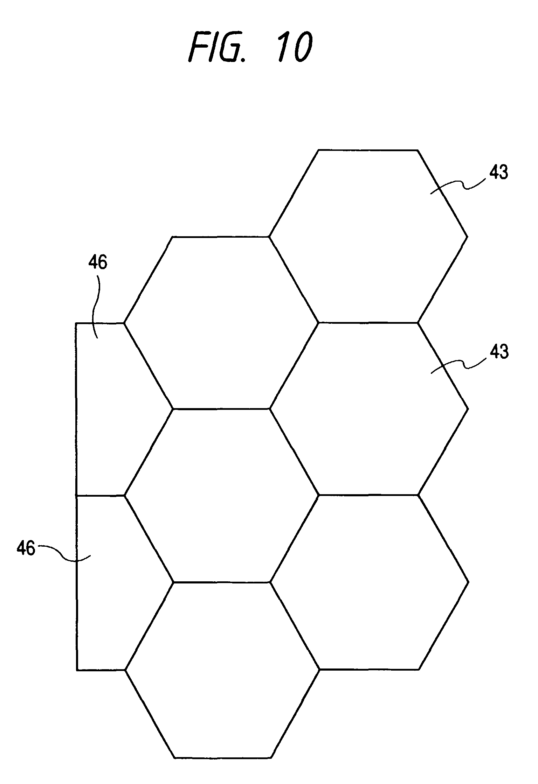

In the case where the solar cell is cut into the regular hexagon as shown in Fig. 9A, unit cells 43 of a solar cell can be filled without any useless area as shown in Fig. 10, and can be set into one module. Thus, since there can be less portions to be discarded than the case where it is cut into a quadrangle, the silicon material can be utilized effectively. Incidentally, in order to make a rectangular module, unit cells 43 at the margin of the module is cut in half as shown by reference numeral 46 in Fig. 10, which are then attached to an end of the module.

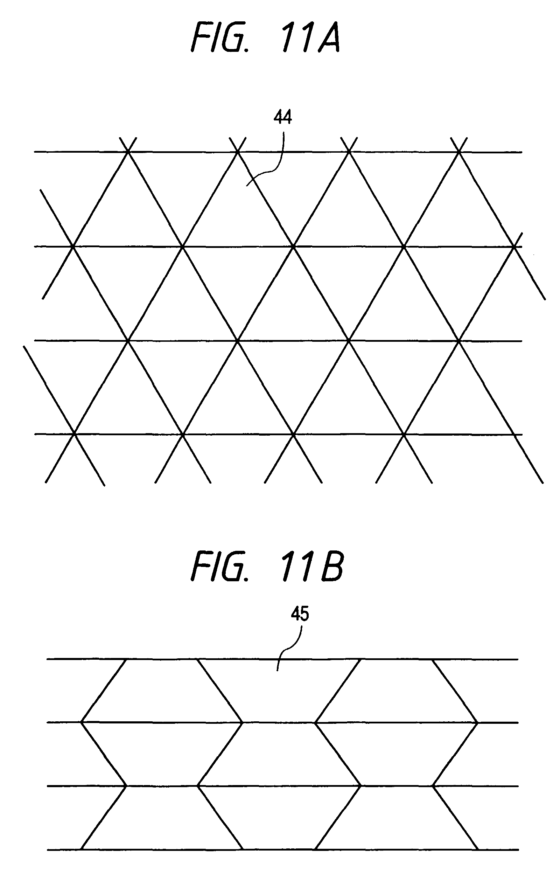

In the case where the solar cell is cut into the triangle as shown in Fig. 9B, outer portions of the triangle may preferably be further cut as shown by the solid lines. Then, solar cell regular triangular unit cells 44 may be arranged as shown in Fig. 11A, or solar cell trapezoidal unit cells 45 may be arranged as shown in Fig. 11B. This enables effective utilization of the silicon material.

Besides the foregoing, the cutting angle of $|\cos\theta| = 1/2$ or $3^{1/2}/2$ may be utilized to prepare a solar cell having geometrical design such as rhombuses so that its area can be utilized effectively. This manner of cutting the active layer is not limited to the epitaxial layer formed on the porous silicon layer, and may be applied to usual semiconductor devices making use of (111) substrates.

According to Embodiment 1, since the (111) substrate is used in the silicon wafer 28, the process can be more free from the abnormal growth on porous layers than the case where (100) substrates are used, and the porous layer can be covered completely with the epitaxial layer. Hence, compared with the case where (100) substrates are used, the process can greatly be improved in yield and solar cells can be produced at a low cost. Also, the cutting of solar cells by utilizing the cleavage directions of the (111) substrate makes small the area of the active layer discarded and enables effective utilization of semiconductor resources.

(Embodiment 2)

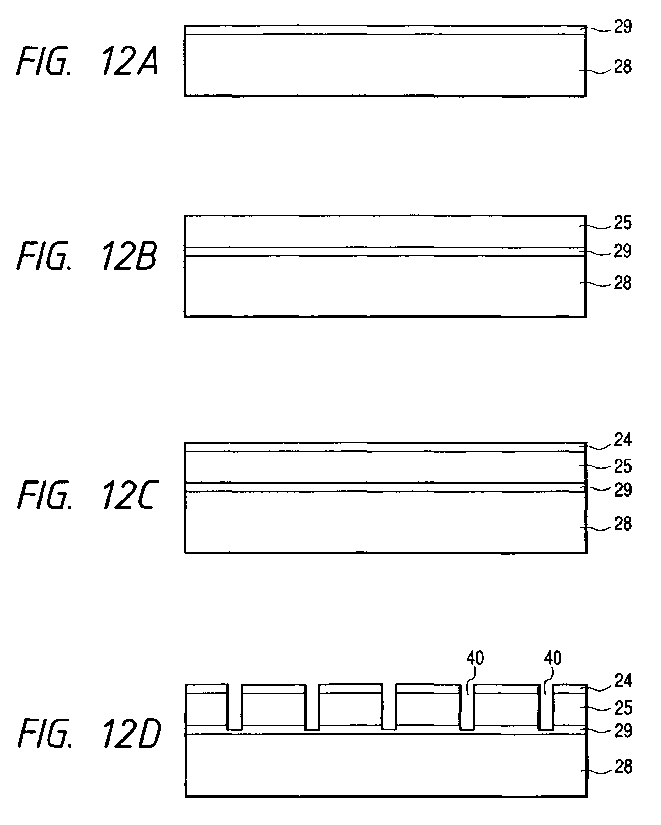

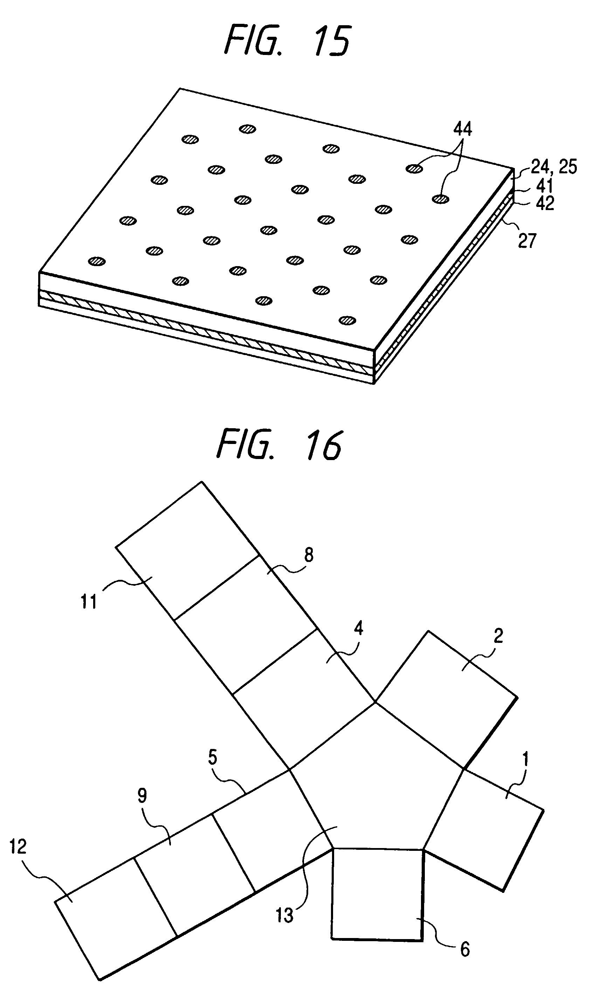

Embodiment 2 is an embodiment in which solar cells are produced using a two-crucible liquid-phase growth system. In the solar cell of Embodiment 2, electrodes are formed using through-holes. Figs. 12A to 12D, Figs. 13A to 13E and Figs. 14A to 14D are diagrammatic cross-sectional views showing steps of a process for producing a solar cell in Embodiment 2. Fig. 15 is a perspective view of the solar cell in Embodiment 2. In these drawings, reference numeral 40 denotes through-holes; 41, an aluminum electrode; 42; an insulating sheet; 43, insulating regions; and 44, through-hole electrodes. Other reference numerals are common to those of members described previously.

The through-hole electrodes 44 shown in Fig. 15 have the function to cause conduction electrons collected to an $n^+$-type silicon layer 24, to move to a SUS stainless steel substrate 27 serving as the negative electrode. The aluminum electrode 41 is connected with a $p^-$-type silicon layer 25, and their connecting area has become a $p^+$-type silicon layer as a result of the baking of aluminum with silicon. Then, when acts as a solar cell, electrons from the positive electrode aluminum electrode 41 are supplied to holes collected to the $p^+$-type silicon layer.

A solar cell production process of Embodiment 2 will be described. First, as shown in Fig. 12A, a porous silicon layer 29 is formed on a (111) silicon wafer 28. The porous silicon layer 29 is formed in the same manner as in Embodiment 1. Next, as shown in Fig. 12B, the $p^-$-type silicon layer 25 is formed on the porous silicon layer 29. Subsequently, as shown in Fig. 12C, the $n^+$-type silicon layer 24 is formed on the $p^-$-type silicon layer 25.

In the steps of forming these $p^-$-type silicon layer 25 and $n^+$-type silicon layer 24, a two-crucible liquid-phase growth system as shown in Fig. 16 is used. Its $p^-$-type silicon layer growth chamber 4, transport chamber 8 and silicon material feed chamber 11 and its $n^+$-type silicon layer growth chamber 5, transport chamber 9 and silicon material feed chamber 12 have the same cross-sectional structure as the one shown in Fig. 2. Reference numeral 1 denotes a loading chamber; 2, a hydrogen annealing chamber; 6, an unloading chamber; and 13, a core.

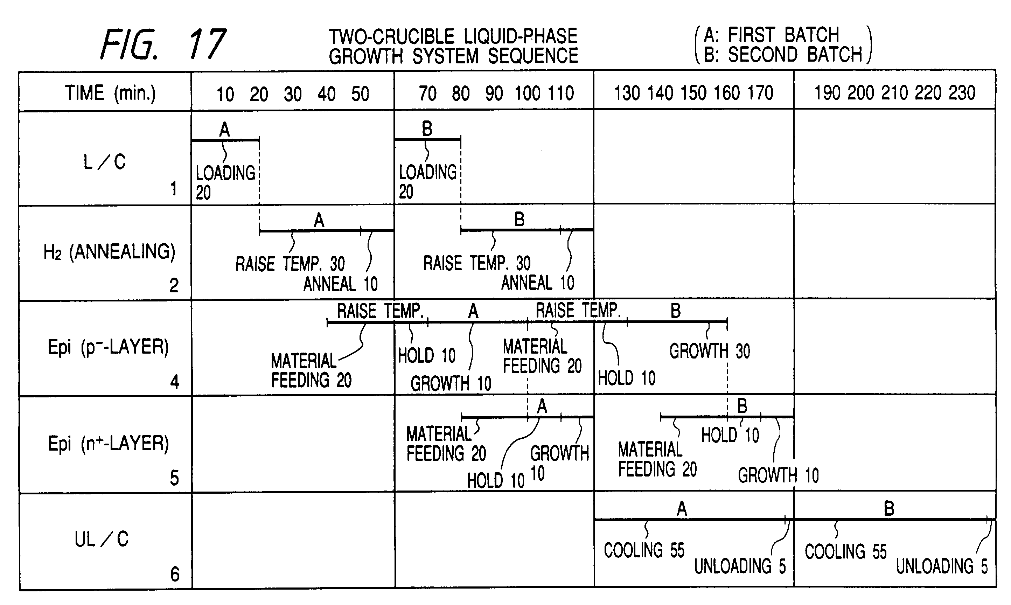

The sequential chart of the steps of forming the $p^-$-type silicon layer 25 and $n^+$-type silicon layer 24 is shown in Fig. 17. Letter symbol A represents the movement of a wafer cassette in the first batch.

The first-batch wafer cassette 18 is loaded in the loading chamber 1 in the first 20 minutes, and is transported to the hydrogen annealing chamber 2. In the hydrogen annealing chamber 2, it takes 30 minutes to raise the temperature of the wafer cassette 18, and hydrogen annealing is carried out for 10 minutes. The hydrogen annealing is carried out in an atmosphere of hydrogen at about 1,040°C.

Then, the wafer cassette 18 is moved to the $p^-$-type silicon layer growth chamber 4 while using the horizontal-direction transport means 20 of the core 13, and the wafer cassette 18 is held for 10 minutes until it reaches the growth temperature. In this course, the melt 14 is cooled and the $p^-$-type silicon becomes supersaturated. Before the wafer cassette 18 is moved to the $p^-$-type silicon layer growth chamber 4, the dissolve-in substrate cassette holding $p^-$-type silicon wafers and so forth is transported from the silicon material feed chamber 11 through the transport chamber 8 and immersed in the melt 14 kept at a high temperature, and the $p^-$-type silicon is kept dissolved in the melt 14. Then, the wafer cassette 18 is immersed in the melt 14, and the temperature of the melt 14 is gradually lowered, whereupon the $p^-$-type silicon layer 25 is epitaxially grown on the surface of the porous silicon layer 29. This growth time is about 30 minutes. In this immersion time, the $p^-$-type silicon layer 25 is grown in a thickness of about 30 $\mu$m as cross-sectionally shown in Fig. 12B.

Next, the wafer cassette 18 is moved from the $p^-$-type silicon layer growth chamber 4 to the $n^+$-type silicon layer growth chamber 5 while using the horizontal-direction transport means 20 of the core 13, and the wafer cassette 18 is held for 10 minutes until it reaches the growth temperature. In this course, the melt 14 is cooled and the $n^+$-type silicon becomes supersaturated. In order to make the melt 14 become supersaturated with $n^+$-type silicon, before the wafer cassette 18 is moved to the $n^+$-type silicon layer growth chamber 5, the dissolve-in substrate cassette holding $n^+$-type silicon wafers and so forth is transported from the silicon material feed chamber 12 through the transport chamber 9 and immersed in the melt 14 kept at a high temperature, and the $n^+$-type silicon is kept dissolved in the melt 14. Then, the wafer cassette 18 is immersed in the melt 14, and the temperature of the melt 14 is gradually lowered, whereupon the $n^+$-type silicon layer 24 is epitaxially grown on the surface of the $p^-$-type silicon layer 25 as cross-sectionally shown in Fig. 12C. This growth time is about 10 minutes.

Thereafter, the wafer cassette 18 is moved from the $n^+$-type silicon layer growth chamber 5 to the unloading chamber 6 using the transport means of the core 13. Then, the wafer cassette 18 is cooled for 55 minutes and taken out in 5 minutes.

Letter symbol B in Fig. 17 represents the movement of the wafer cassette in the second batch. The second-batch wafer cassette is moved in the same manner as the first-batch wafer cassette, thus the description is omitted. According to the liquid-phase growth system of Embodiment 2, the liquid-phase epitaxy for every batch can be completed at an interval of 60 minutes.

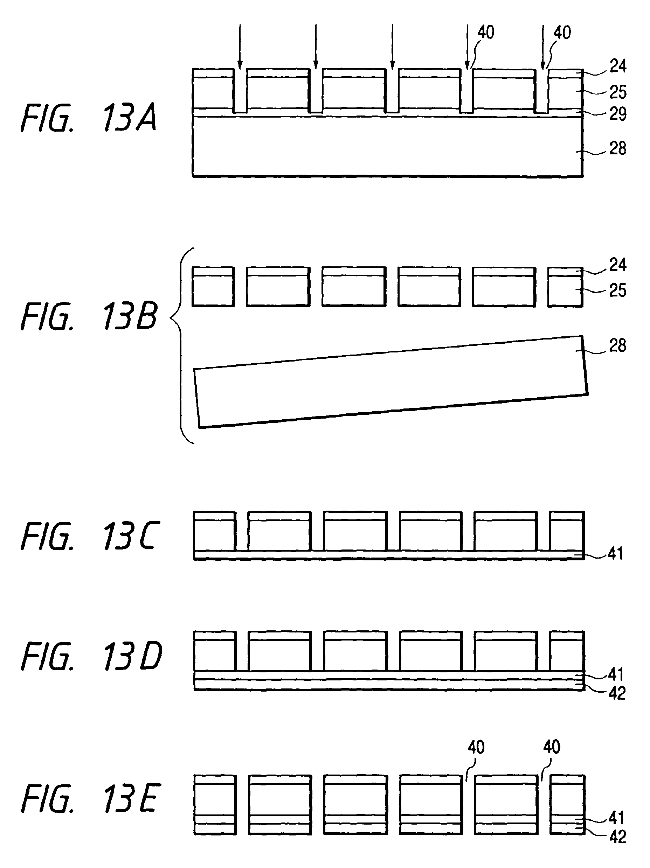

After the growth of epitaxial layers 24 and 25 as described above has been completed, through-holes 40 are so made as to pass through the epitaxial layers 24 and 25 from the surface by means of a laser to make the porous silicon layer 29 uncovered. Then, the substrate with these layers is immersed in a wet etchant such as a mixture solution of hydrofluoric acid and hydrogen peroxide. As a result, as shown by arrows in Fig. 13A, the wet etchant permeates through the through-holes 40, so that the porous silicon layer 29 is selectively etched. Thus, as shown in Fig. 13B, the epitaxial layers 24 and 25 can be separated from the silicon wafer 28.

The silicon wafer 28 is again subjected to anodizing to form on its surface the porous silicon layer 29 as shown in Fig. 12A, and is again put to the production process shown in Figs. 12B to 12D and Fig. 13A so that the silicon wafer 28 can be utilized many times. This method enables production of about 100 sheets of wafer-size solar cells from one sheet of silicon wafer.

Thereafter, to the back of the $p^-$-type silicon layer 25, an Al sheet that forms the aluminum electrode 41 is attached to provide the cross-sectional structure as shown in Fig. 13C. Then, to the back of the aluminum electrode 41, the insulating sheet 42 is attached in such a way that it comes in contact with the aluminum electrode 41, to provide the cross-sectional structure as shown in Fig. 13D. Then, this is again irradiated with laser light under registration to the through-holes to make holes in the aluminum electrode 41 and insulating sheet 42 as shown in Fig. 13E.

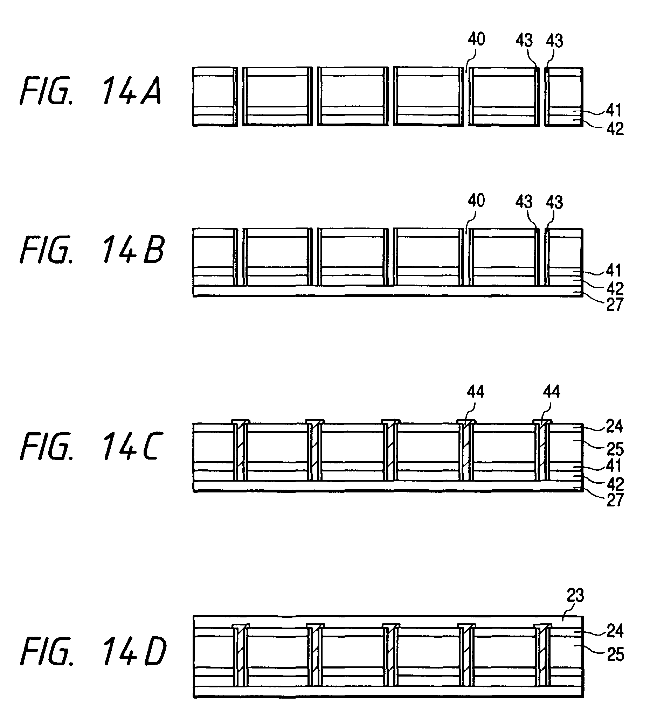

Next, as shown in Fig. 14A, the insulating regions 43 are formed on the through-hole walls. The insulating regions 43 are formed by, e.g., first filling the through-holes 40 with an insulating material and thereafter making holes by means of a laser. Then, as shown in Fig. 14B, the SUS stainless steel substrate 27 is attached in such a way that it comes into contact with the insulating sheet 42. Then, the through-holes 40 are filled with a Cu paste by a process such as dotting to form the through-hole electrodes 44 as shown in Fig. 14C. Then, as shown in Fig. 14D, an anti-reflection layer 23 of $TiO_2$ is formed on the surface of the $n^+$-type silicon layer 24 by coating, thus a solar cell is completed.

In the liquid-phase growth system of Embodiment 2, as shown at 110 to 120 minutes in Fig. 17, the annealing in the hydrogen annealing chamber 2 and the liquid-phase epitaxy in the chamber 4 for growing the $p^-$-type silicon layer are made simultaneously. Also, as shown at 50 to 60 minutes in Fig. 17, the annealing in the hydrogen annealing chamber 2 and the dissolving of semiconductor material in the chamber for growing the $p^+$-type silicon layer are made simultaneously. According to Embodiment 2, contact electrodes are enacted by through-hole contacts, and hence solar cells having less shadow loss and a good efficiency can be produced.

(Embodiment 3)

Embodiment 3 is an embodiment in which solar cells are produced using a five-crucible liquid-phase growth system. The production process and structure of the solar cell of Embodiment 3 are the same as those of the solar cells in Embodiment 2 as described with reference to Figs. 12A to 12D, Figs. 13A to 13E, Figs. 14A to 14D and Fig. 15.

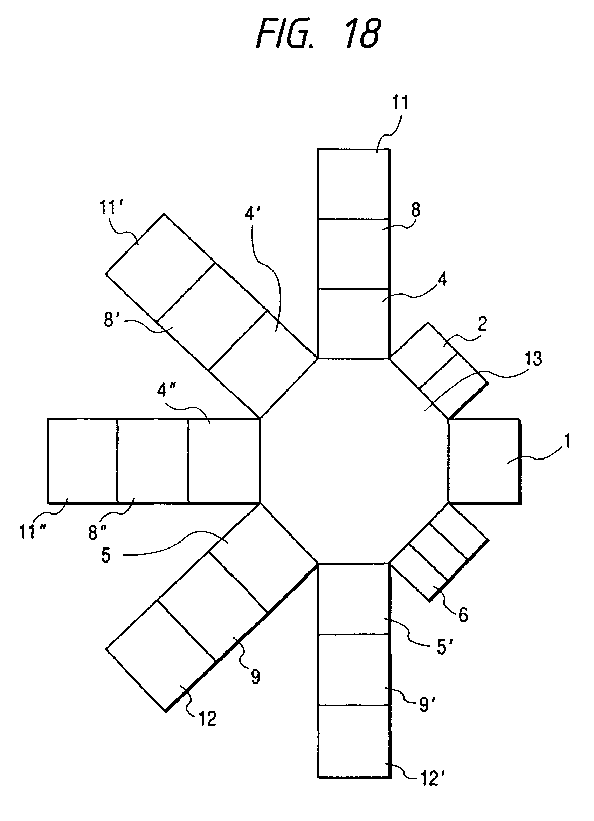

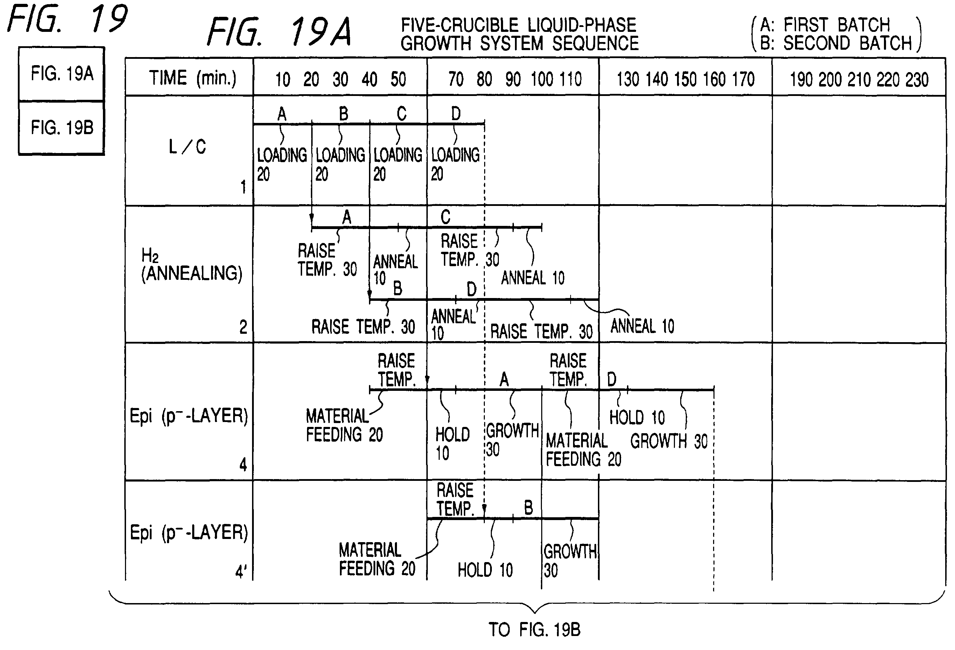

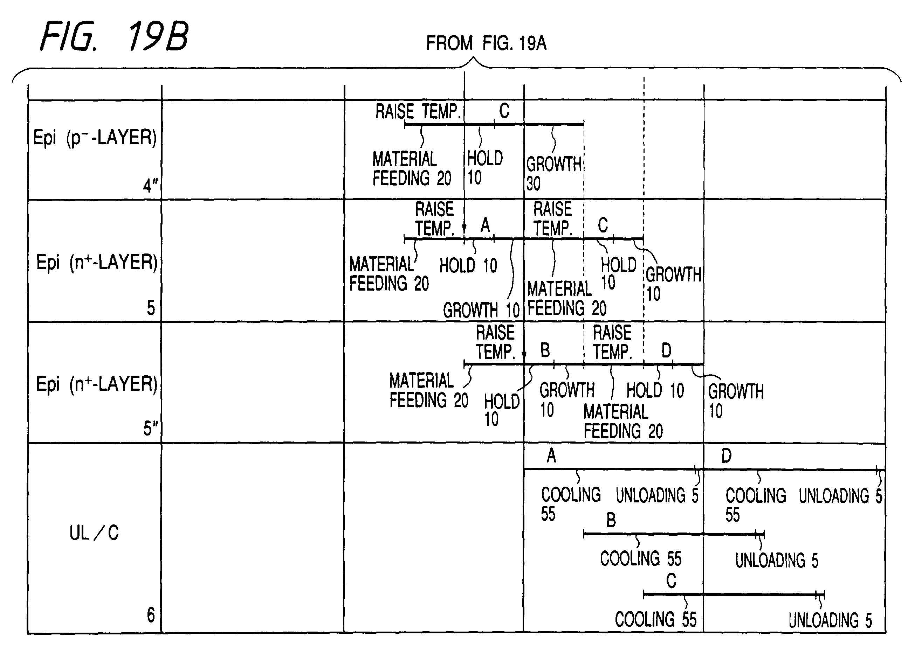

Fig. 18 is a diagrammatic top plan view of a liquid-phase growth system according to Embodiment 3. Figs. 19A and 19B are time charts showing the sequence of operating the liquid-phase growth system in Embodiment 3. The liquid-phase growth system in Embodiment 3 has three chambers for growing $p^-$-type silicon layers and two chambers for growing $n^+$-type silicon layers. Thus, it follows that there are five crucibles for the liquid-phase growth chambers. Reference numerals 4, 4' and 4'' in Fig. 18 all denote $p^-$-type silicon layer growth chambers, and transport chambers 8, 8' and 8'' and silicon material feed chambers 11, 11' and 11'' are correspondingly provided, respectively. Reference numerals 5 and 5' in Fig. 18 denote $n^+$-type silicon layer growth chambers, and transport chambers 9 and 9' and silicon material feed chambers 12 and 12' are correspondingly provided, respectively. Also, reference numeral 1 denotes a loading chamber, which is in the number of one; 2, hydrogen annealing chambers, which are in the number of two; 6, unloading chambers, which are in the number of three. Reference numeral 13 denotes a core, which is provided therein with a transport means for transporting wafer cassettes to the respective chambers 1 to 6.

To carry out liquid-phase epitaxy using the liquid-phase growth system of Embodiment 3, a substrate comprising the silicon wafer 28 and the porous silicon layer 29 formed thereon as shown in Fig. 12A is formed by the anodizing process as described in Embodiment 1. Next, as shown in Fig. 12B, the $p^-$-type silicon layer 25 is formed on the porous silicon layer 29. Subsequently, as shown in Fig. 12C, the n$^+$-type silicon layer 24 is formed on the p$^-$-type silicon layer 25.

In the steps of forming these p$^-$-type silicon layer 25 and n$^+$-type silicon layer 24, the five-crucible liquid-phase growth system described with reference to Fig. 18 is used. Its p$^-$-type silicon layer growth chambers 4, 4' and 4", transport chambers 8, 8' and 8" and silicon material feed chambers 11, 11' and 11" and its n$^+$-type silicon layer growth chambers 5 and 5', transport chambers 9 and 9' and silicon material feed chambers 12 and 12' have the same cross-sectional structure as the one shown in Fig. 2.

The sequence of the steps of forming the p$^-$-type silicon layer 25 and n$^+$-type silicon layer 24 is shown in Figs. 19A and 19B. Letter symbol A represents the movement of a wafer cassette 18 in the first batch.

The first-batch wafer cassette 18 is loaded in the loading chamber 1 in the first 20 minutes, and is transported to the hydrogen annealing chamber 2. In the hydrogen annealing chamber 2, it takes 30 minutes to raise the temperature of the wafer cassette 18, and hydrogen annealing is carried out for 10 minutes. The hydrogen annealing is carried out in an atmosphere of hydrogen at about 1,040°C.

Then, the wafer cassette 18 is moved to the p$^-$-type silicon layer growth chamber 4 while using the horizontal-direction transport means 20 of the core 13, and the wafer cassette 18 is held for 10 minutes until it reaches the growth temperature. In this course, the melt 14 is cooled and the p$^-$-type silicon becomes supersaturated. Before the wafer cassette 18 is moved to the p$^-$-type silicon layer growth chamber 4, the dissolve-in substrate cassette holding p$^-$-type silicon wafers and so forth is transported from the silicon material feed chamber 11 through the transport chamber 8 and immersed in the melt 14 kept at a high temperature, and the p$^-$-type silicon is kept dissolved in the melt 14. Then, the wafer cassette 18 is immersed in the melt 14, and the temperature of the melt 14 is gradually lowered, whereupon the p$^-$-type silicon layer 25 is epitaxially grown on the surface of the porous silicon layer 29. This growth time is about 30 minutes. In this immersion time, the p$^-$-type silicon layer 25 is grown in a thickness of about 30 μm as cross-sectionally shown in Fig. 12B.

Next, the wafer cassette 18 is moved from the p$^-$-type silicon layer growth chamber 4 to the n$^+$-type silicon layer growth chamber 5 while using the horizontal-direction transport means 20 of the core 13, and the wafer cassette 18 is held for 10 minutes until it reaches the growth temperature. In this course, the melt 14 is cooled and the n$^+$-type silicon becomes supersaturated. In order to make the melt 14 become supersaturated with n$^+$-type silicon, before the wafer cassette 18 is moved to the n$^+$-type silicon layer growth chamber 5, the dissolve-in substrate cassette holding n$^+$-type silicon wafers and so forth is transported from the silicon material feed chamber 12 through the transport chamber 9 and immersed in the melt 14 kept at a high temperature, and the n$^+$-type silicon is kept dissolved in the melt 14. Then, the wafer cassette 18 is immersed in the melt 14, and the temperature of the melt 14 is gradually lowered, whereupon the n$^+$-type silicon layer 24 is epitaxially grown on the surface of the p$^-$-type silicon layer 25 as cross-sectionally shown in Fig. 12C. This growth time is about 10 minutes.

Thereafter, the wafer cassette 18 is moved from the n$^+$-type silicon layer growth chamber 5 to the unloading chamber 6 using the transport means of the core 13. Then, the wafer cassette 18 is cooled for 55 minutes and taken out in 5 minutes.

Letter symbol B in Figs. 19A and 19B represents the movement of the wafer cassette in the second batch; C, the movement of the wafer cassette in the third batch; and D, the movement of the wafer cassette in the fourth batch. The second-batch wafer cassette in B is subjected to hydrogen annealing in the hydrogen annealing chamber 2, and thereafter moved to the p$^-$-type silicon layer growth chamber 4', where the p$^-$-type silicon layer is grown in the same step as the first batch in A. Thereafter, the second-batch wafer cassette is moved to the n$^+$-type silicon layer growth chamber 5', where the n$^+$-type silicon layer is grown.

The third-batch wafer cassette in C is moved in the order of the p$^-$-type silicon layer growth chamber 4" and the n$^+$-type silicon layer growth chamber 5.

The fourth-batch wafer cassette in D is moved in the order of the p$^-$-type silicon layer growth chamber 4 and the n$^+$-type silicon layer growth chamber 5".

The reason why there are two hydrogen annealing chambers and three unloading chambers is to make it possible to put therein two cassettes and three cassettes simultaneously. According to the liquid-phase growth system of Embodiment 3, the liquid-phase epitaxy for every batch can be completed at an interval of 60 minutes.

In the liquid-phase growth system of Embodiment 3, as shown at 130 to 140 minutes in Figs. 19A and 19B, the liquid-phase epitaxy is made simultaneously in the chamber 4 for growing the p$^-$-type silicon layer, chamber 4" for growing the p$^-$-type silicon layer and chamber 5' for growing the n$^+$-type silicon layer. Also, as shown at 110 to 120 minutes in Figs. 19A and 19B, the annealing in the hydrogen annealing chamber 2 and the liquid-phase epitaxy in the chamber 4" for growing the p$^-$-type silicon layer are made simultaneously. Still also, as shown at 50 to 60 minutes in Figs. 19A and 19B, the annealing in the hydrogen annealing chamber 2 and the dissolving of semiconductor material in the chamber 4 for growing the p$^-$-type silicon layer are made simultaneously. In the liquid-phase growth system of Embodiment 3, three chambers for growing p$^-$-type silicon layers, which require a time for their growth, are provided so that the throughput of liquid-phase epitaxy can be improved. Hence, solar cells can be produced in a high throughput.

EXAMPLES

(Example 1)

A silicon layer was grown on a porous silicon layer by liquid-phase epitaxy.

First, the surface of a 5-inch p-type (111) silicon wafer was made into a porous silicon layer. This step was carried out using the anodizing unit shown in Fig. 6B.

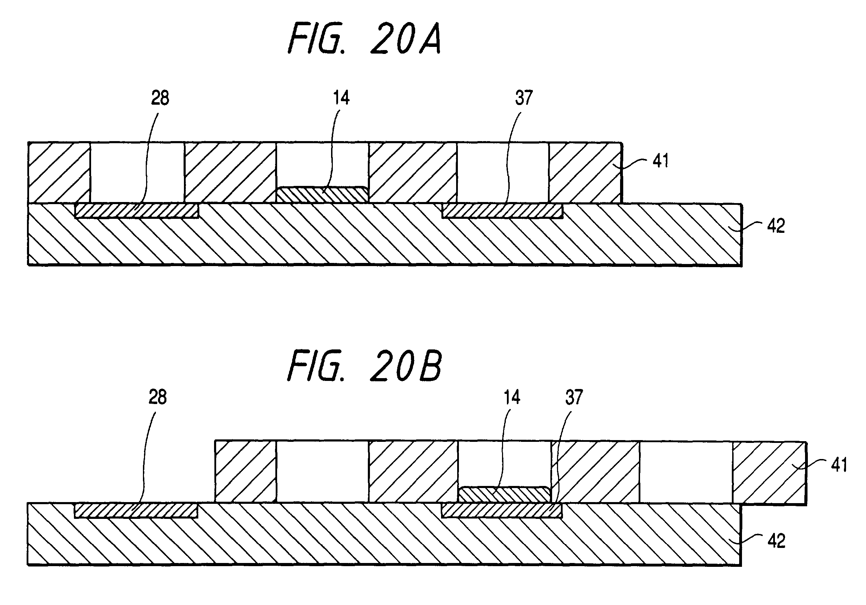

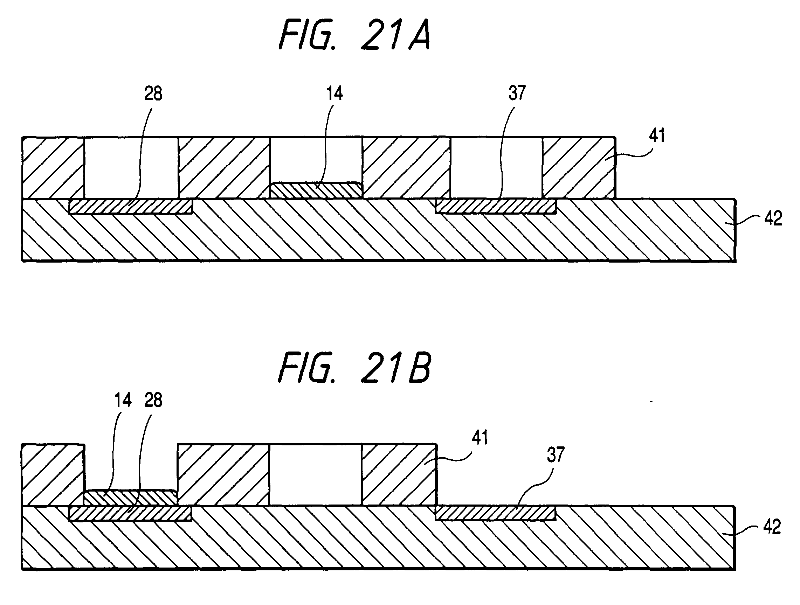

Then, on this porous silicon layer, a silicon layer was epitaxially grown by liquid-phase epitaxy. Here, sliding boat type liquid-phase epitaxy as shown in Figs. 20A and 20B and Figs. 21A and 21B was employed. In the sliding boat type liquid-phase epitaxy, the silicon wafer having the porous silicon layer, an indium melt and a dissolve-in silicon wafer were set in a sliding boat.

Fig. 20A is a diagrammatic cross-sectional views of the sliding boat, standing at the standard position. In Fig. 20A, reference numeral 41 denotes an upper boat; an 42, a lower boat. Other reference numerals denote the same members as those described previously.

First, at the standard position shown in Fig. 20A, the wafer 28 having the porous silicon layer, the melt 14 and the dissolve-in silicon wafer 37 were annealed together with the boat in an atmosphere of $H_2$ at 1,040°C for 1 minute. Thereafter, as shown in Fig. 20B, silicon was dissolved in the indium melt 14 from the dissolve-in silicon wafer 37 at 960°C. Then, as shown in Fig. 21A, the boat was returned to the standard position, and the dissolve-in silicon wafer 37 was separated from the melt 14. Thereafter, the temperature of the boat was lowered to 950°C to make the silicon in the melt 14 become supersaturated. Then, as shown in Fig. 21B, the upper boat was shifted, and annealed from 950°C to 940°C, and an epitaxial silicon layer was grown on the porous silicon layer. Then, as shown in Fig. 20A, the boat was returned to the standard position and brought down to room temperature, and then the silicon wafer 28 was taken out.

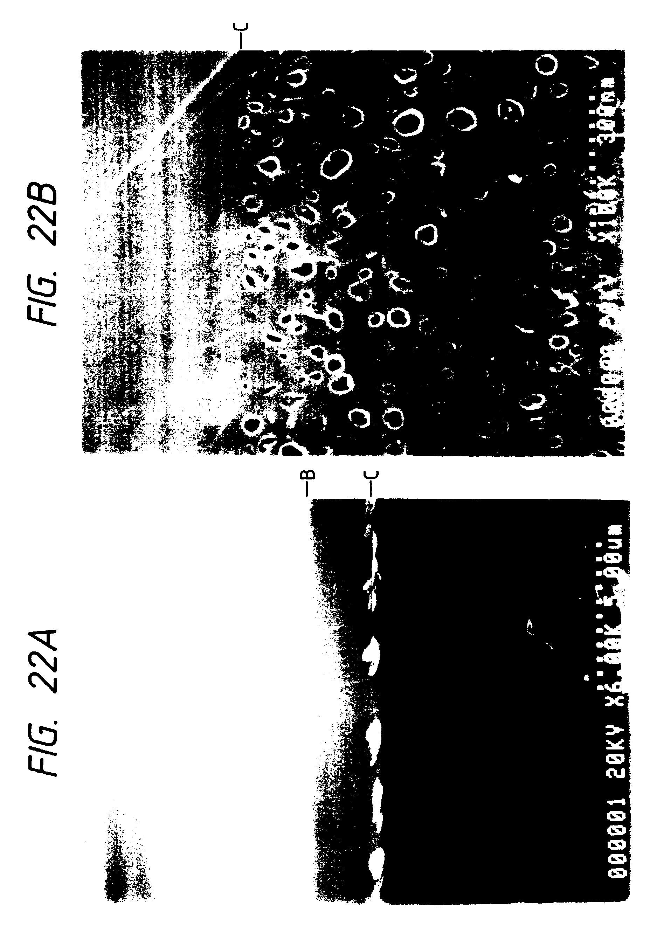

Cross-sectional photographs taken by scanning electron microscopy (SEM) of the silicon wafer 28 thus taken out are shown in Figs. 22A and 22B. In Fig. 22A, the part upper than a solid line B is the surface, and the part lower than the solid line B is a cross section. The epitaxial silicon layer lies between the solid line B and a solid line C, and the porous silicon layer lies beneath the solid line C. The epitaxial silicon layer covers the porous silicon layer fully completely, and its surface is flat. Fig. 22B is an enlarged sectional photograph of Fig. 22A. The porous silicon layer having pores lies at the part lower than the solid line C, and the epitaxial silicon layer has nicely been grown at the part upper than the solid line C. Hence, this substrate can be sent to the subsequent steps, and semiconductor devices having epitaxial silicon layers as active layers can stably be provided.

(Comparative Example)

On a p-type (100) silicon wafer 28, the anodizing and liquid-phase epitaxy were made under the same conditions as in Example 1, where the growth took place as shown previously in Fig. 23A an 23B. Namely, the epitaxial silicon layer did not cover the porous silicon layer completely, and the porous silicon layer remained uncovered to the surface. Also, the epitaxial silicon had been grown in a pyramidal mass, and such a substrate was not able to be sent to the subsequent steps.

(Example 2)

In order to show that the principal plane of the porous semiconductor used in the present invention need not be a strict (111)-plane, the following experiment was made.

As 5-inch p-type (111) silicon wafers, used were those whose principal planes were inclined from the strict (111)-plane by 0°03′ in X-direction and 0°00′ in Y-direction (hereinafter "wafer A"); by 0°00′ in X-direction and 0°08′ in Y-direction (hereinafter "wafer B"); and by 0°12′ in X-direction and 0°24′ in Y-direction (hereinafter "wafer C"). Any wafer A, B or C has an orientation flat on (1$\bar{1}$1) surface. The experiment was made under the same conditions as in Example 1 except the following: Annealing time in $H_2$: 15 minutes; dissolve-in time: 1 hour and 40 minutes; annealing: from 950°C to 710°C; anodizing: 10 minutes at 1.0 A and thereafter 100 seconds at 2.8 A.

As a result, stacking fault density was $5.8 \times 10^2$ cm$^{-2}$ in the case where the wafer A was used; $1.2 \times 10^4$ cm$^{-2}$ in the case where the wafer B was used; and $5.6 \times 10^5$ cm$^{-2}$ in the case where the wafer B was used. Also, the epitaxially grown layers showed a good continuity when any wafers were used. The above results proved that good epitaxially grown layers can be formed even when the principal plane of the porous semiconductor is not a strict (111)-plane.

According to the epitaxial crystal growth process of the present invention, using the porous semiconductor having the principal plane of (111)-plane, the surface of the porous semiconductor can be covered completely with the epitaxial layer without any abnormal growth and stably. Hence, compared with the case where (100) substrates are used, the process can greatly be improved in yield, and semiconductor devices such as solar cells can be produced at a low cost.

According to the semiconductor device whose active layer which serves photoelectric conversion has the principal plane of (111)-plane, solar cells can be cut by utilizing the cleavage directions of the (111) substrate. This makes small the area of the active layer discarded and enables effective utilization of semiconductor resources.

A crystalline silicon layer is epitaxially grown on a substrate having a porous silicon layer on the surface. In making epitaxial growth by liquid-phase epitaxy, a silicon material is previously dissolved in a melt at a high temperature and then the silicon substrate to be subjected to epitaxy is immersed in the melt. Then, its temperature is gradually lowered, whereby the silicon precipitated from the melt is epitaxially grown on the silicon substrate. In this epitaxy, a substrate having the principal plane of (111)-plane is used as the silicon substrate.

This provides a process by which a crystalline silicon layer covering a porous silicon layer completely is epitaxially grown on the porous silicon layer without causing any abnormal growth.

**Claims**

1. A crystal growth process comprising forming an epitaxial semiconductor layer on a porous semiconductor, wherein the porous semiconductor layer has the principal plane of (111)-plane.

2. The crystal growth process according to claim 1, wherein the porous semiconductor is formed by subjecting the surface of a (111) silicon wafer to anodizing.

3. The crystal growth process according to claim 1, which is carried out by liquid-phase epitaxy.

4. The crystal growth process according to claim 1, wherein the deviation of principal plane from the strict (111) plane is within 24′.

5. A semiconductor device production process comprising forming a porous semiconductor on the surface of a semiconductor substrate, and forming on the porous semiconductor an epitaxial semiconductor layer used as an active layer, wherein the semiconductor substrate has the principal plane of (111)-plane.

6. The semiconductor device production process according to claim 5, wherein the deviation of principal plane from the strict (111) plane is within 24′.

7. A semiconductor device comprising a substrate and formed thereon an active layer having the principal plane of (111)-plane; the active layer being used in photoelectric conversion.

8. The semiconductor device according to claim 7, wherein, where an angle formed by any arbitrary two cutting lines not coming into coincidence is represented by $\theta$, the active layer has a cutting angle of $|\cos\theta| = 1/2$ or $3^{1/2}/2$.

9. The semiconductor device according to claim 7, wherein the deviation of principal plane from the strict (111) plane is within 24′.

FIG. 1

FIG. 2

# FIG. 3A

# FIG. 3B

FIG. 4A

29
28

FIG. 4B

26
29
28

FIG. 4C

25
26
29
28

FIG. 4D

24
25
26
29
28

FIG. 4E

21
24
25
26
29
28

*FIG. 5A*

*FIG. 5B*

*FIG. 5C*

## FIG. 6A

## FIG. 6B

EP 0 969 499 A2

## FIG. 7  THREE-CRUCIBLE LIQUID-PHASE GROWTH SYSTEM SEQUENCE

(A: FIRST BATCH
B: SECOND BATCH)

| TIME (min.) | 10 20 30 40 50 | 70 80 90 100 110 | 130 140 150 160 170 | 190 200 210 220 230 |
|---|---|---|---|---|
| L/C<br>1 | A<br>LOADING<br>20 | B<br>LOADING<br>20 | | |
| H₂ (ANNEALING)<br>2 | A<br>RAISE TEMP. 30<br>ANNEAL 10 | B<br>RAISE TEMP. 30<br>ANNEAL 10 | | |
| Epi (p⁺-LAYER)<br>3 | MATERIAL<br>FEEDING 20<br>HOLD 10 | A<br>GROWTH MATERIAL<br>10  FEEDING 20 | B<br>GROWTH 10<br>HOLD 10 | |
| Epi (p⁻-LAYER)<br>4 | | A<br>MATERIAL<br>FEEDING 20 HOLD 10  GROWTH<br>30 | B<br>MATERIAL  GROWTH 30<br>FEEDING 20 HOLD 10 | |
| Epi (n⁺-LAYER)<br>5 | | MATERIAL<br>FEEDING 20<br>HOLD 10 | A<br>GROWTH MATERIAL HOLD 10<br>10  FEEDING 20 | B<br>GROWTH 10 |
| UL/C<br>6 | | | A<br>COOLING 55 | B<br>UNLOADING 5  COOLING 55 |

# FIG. 8

## FIG. 9A

(111)

[10$\overline{1}$]

[01$\overline{1}$]

[1$\overline{1}$0]

[1$\overline{1}$0]

[01$\overline{1}$]

[10$\overline{1}$]

## FIG. 9B

(111)

44

[$\overline{1}\overline{1}$2]

[2$\overline{1}\overline{1}$]

45

[01$\overline{1}$]

[1$\overline{1}$0]

[$\overline{1}$2$\overline{1}$]

[$\overline{1}$2$\overline{1}$]

[2$\overline{1}\overline{1}$]

[$\overline{1}\overline{1}$2]

[10$\overline{1}$]

# FIG. 10

## FIG. 11A

## FIG. 11B

*FIG. 12A*

29
28

*FIG. 12B*

25
29
28

*FIG. 12C*

24
25
29
28

*FIG. 12D*

40    40

24
25
29
28

FIG. 13A

FIG. 13B

FIG. 13C

FIG. 13D

FIG. 13E

FIG. 14A

FIG. 14B

FIG. 14C

FIG. 14D

## FIG. 15

## FIG. 16

## FIG. 17 — TWO-CRUCIBLE LIQUID-PHASE GROWTH SYSTEM SEQUENCE

(A: FIRST BATCH / B: SECOND BATCH)

| TIME (min.) | 10 20 30 40 50 | 70 80 90 100 110 | 130 140 150 160 170 | 190 200 210 220 230 |
|---|---|---|---|---|
| L / C   1 | A — LOADING 20 | B — LOADING 20 | | |
| H₂ (ANNEALING)   2 | A — RAISE TEMP. 30 / ANNEAL 10 | B — RAISE TEMP. 30 / ANNEAL 10 | | |
| Epi (p⁻-LAYER)   4 | RAISE TEMP. A / MATERIAL FEEDING 20 | HOLD 10 / GROWTH 10 / MATERIAL FEEDING 20 | RAISE TEMP. B / HOLD 10 / GROWTH 30 | |
| Epi (n⁺-LAYER)   5 | | A — MATERIAL FEEDING 20 / GROWTH 10 / HOLD 10 | B — MATERIAL FEEDING 20 / HOLD 10 / GROWTH 10 | |
| UL / C   6 | | | A — COOLING 55 / UNLOADING 5 | B — COOLING 55 / UNLOADING 5 |

EP 0 969 499 A2

# FIG. 18

# FIG. 19

| FIG. 19A |
|----------|
| FIG. 19B |

## FIG. 19A — FIVE-CRUCIBLE LIQUID-PHASE GROWTH SYSTEM SEQUENCE

(A: FIRST BATCH)
(B: SECOND BATCH)

| TIME (min.) | 10 20 30 40 50 | 70 80 90 100 110 | 130 140 150 160 170 | 190 200 210 220 230 |
|---|---|---|---|---|
| L / C  1 | A — LOADING 20 / B — LOADING 20 / C — LOADING 20 / D — LOADING 20 | | | |
| H₂ (ANNEALING)  2 | A RAISE TEMP. 30 / ANNEAL 10 / B RAISE TEMP. 30 | C RAISE TEMP. 30 / ANNEAL 10 / D ANNEAL 10 / RAISE TEMP. 30 | ANNEAL 10 | |
| Epi (p⁻-LAYER)  4 | RAISE TEMP. / MATERIAL FEEDING 20 | HOLD 10 / GROWTH 30 / A RAISE TEMP. / MATERIAL FEEDING 20 | HOLD 10 / D GROWTH 30 | |
| Epi (p⁻-LAYER)  4' | MATERIAL FEEDING 20 | RAISE TEMP. / B HOLD 10 / GROWTH 30 | | |

TO FIG. 19B

EP 0 969 499 A2

# FIG. 19B

| Epi (p⁻-LAYER) 4″ | | | RAISE TEMP.    C<br>MATERIAL FEEDING 20   HOLD 10   GROWTH 30 | | |
| Epi (n⁺-LAYER) 5 | | | RAISE TEMP.   A    RAISE TEMP.   C<br>MATERIAL FEEDING 20   HOLD 10   GROWTH 10   MATERIAL FEEDING 20   HOLD 10   GROWTH 10 | | |
| Epi (n⁺-LAYER) 5″ | | | RAISE TEMP.   B    RAISE TEMP.   D<br>MATERIAL FEEDING 20   HOLD 10   GROWTH 10   MATERIAL FEEDING 20   HOLD 10   GROWTH 10 | | |
| UL / C 6 | | | A     D<br>COOLING 55   UNLOADING 5    COOLING 55   UNLOADING 5<br>B<br>COOLING 55   UNLOADING 5<br>C<br>COOLING 55   UNLOADING 5 | | |

EP 0 969 499 A2

# FIG. 20A

# FIG. 20B

EP 0 969 499 A2

FIG. 21A

FIG. 21B

FIG. 22A

FIG. 22B

FIG. 23A

FIG. 23B

# FIG. 24